# Europäisches Patentamt

# European Patent Office

# Office européen des brevets

(19)

(11) Publication number: **0 031 498**
A2

(12) **EUROPEAN PATENT APPLICATION**

(21) Application number: **80107632.4**

(22) Date of filing: **04.12.80**

(51) Int. Cl.³: **G 06 F 11/14,** G 06 F 11/26

(30) Priority: **26.12.79 US 106605**

(43) Date of publication of application: **08.07.81**
**Bulletin 81/27**

(84) Designated Contracting States: **DE FR GB**

(71) Applicant: **International Business Machines Corporation, Armonk, N.Y. 10504 (US)**

(72) Inventor: **Carusone, Anthony Jr., 2928 Glenwood Drive, Boulder Colorado 80301 (US)**
Inventor: **Clark, Phillip Dwaine, 4711 Ipswich Street, Boulder Colorado 80301 (US)**
Inventor: **Miller, Russell Neil, 4935 Qualla Drive, Boulder Colorado 80303 (US)**

(74) Representative: **Hawkins, Anthony George Frederick, IBM United Kingdom Patent Operations Hursley Park, Winchester Hants. S021 2JN (GB)**

(54) **Digital data processing system including means for verifying data transferred from a non-volatile to a volatile store.**

(57) A data processing system includes a volatile store (12) and a non-volatile store (15) for holding data from the volatile store during power-off periods. During a power-on sequence, the non-volatile store data is verified by providing a sequence of test addresses to a readonly store (22). In response to each test address, a reference address is applied to the non-volatile store, reference data representing data expected from the reference address is applied to a register (25) and a diagnostic address is applied to a register (26). Data actually read from the non-volatile store is then applied to a register (29), and this data is compared with that in register (25) by comparator (21) to provide signals for a control system (210) to effect either the provision of the next test address in the sequence or the diagnostic address to the read-only store.

0031498

DIGITAL DATA PROCESSING SYSTEM INCLUDING MEANS
FOR VERIFYING DATA TRANSFERRED FROM A
NON-VOLATILE TO A VOLATILE STORE

This invention relates to digital data processing systems and
in particular to such systems including means for verifying data
transferred from a non-volatile to a volatile data store therein.

In systems employing a non-volatile store, the control program
must be stored in a nonvolatile memory if the system is to retain
the program during periods when no power is supplied, either
intentionally because of power outages or transients. Read-Only
memories are commonly used but have the disadvantage of having to
be completely replaced if changes, even of a minor nature, are
made to the program.

Using a recording media, e.g., a magnetic disc device, while
more expensive for small programs than ROM's, is cost-effective
for larger programs and has the advantage of being readily alterable.
The programs stored on a media must be loaded into a system memory
such as a Random Access Memory (RAM) for efficient utilization.

Because of the complexity of a disc device (or other read/write
media), however, the number of expected malfunctions increases.
If a malfunction occurs while a program is being loaded into the
system memory, the operation of a controlled system must be
inhibited until the malfunction is corrected and the operation of
the recording media validated to ensure that the controlling
program is correctly loaded.

The device complexity aggravates the problems of finding and repairing the cause of a malfunction. Therefore, it is desirable for a diagnostic routine to be invoked to exercise or to attempt to exercise that part of the device involved in the malfunction.

U.S. patent 3,939,453 shows a system for providing diagnostic information to direct an operator through manual or semimanual functions by displaying digits corresponding to numbered entries in a look-up table. The operator, however, must actuate the machine being tested.

U.S. patent 4,034,194 shows a test apparatus that must be attached to the machine being tested. The test apparatus performs a series of diagnostic routines and produces an indication if a fault exists. The test data is transferred to the machine under test for printing and comparison for validity.

These systems require operator intervention and a stored program for diagnostics is selected by the operator. The present invention relates to an arrangement in which diagnostics are entered automatically.

According to the invention, there is provided a digital data processing system comprising a non-volatile data store which is coupled through a system controller to a volatile data store and a data processor, the system being operable to save data during power-off periods by storing data from the volatile store in the non-volatile store and to transfer data from the non-volatile store to the volatile store during a power-on sequence following a power-off period characterised by verifying means for verifying data from the non-volatile store prior to transfer to the volatile store during a power-on sequence, said verifying means comprising a read-only store, first means for providing a sequence of test addresses to the read-only store to derive therefrom, for each test address, a non-volatile store reference address, reference data related to test data at the reference address, and an address of a diagnostic routine in the read-only store related to a portion of the non-volatile store including the reference address, second means for holding said reference data, third means for holding said diagnostic address, fourth means for holding data read from the reference address, and comparing means for comparing the contents of said second and fourth means to provide, in accordance with the relationship of data therein, an output to control means to cause the control means either to direct the next test address in the sequence, or said diagnostic address, to the read-only store.

The invention will now be described, by way of example, with reference to the accompanying drawings, in which :-

Figure 1 is a diagram of a data processing system in which the invention can be advantageously utilized;

Figure 2 is a block diagram of an embodiment of the invention;

Figure 3 is a logic diagram of a controller usable in the system of Figure 2;

Figure 4 is a state flow diagram showing the sequencing of the controller shown in Figure 3;

Figure 5 is a flowchart of an example of a test program, shown in more detail in Table I;

Figure 6 is a flowchart of an example of an error subroutine, shown in more detail in Table II;

Figure 7 is a flowchart of an example of a diagnostic subroutine, shown in more detail in Table III;

Figure 8 is a flowchart of an example of a stop-start-cancel subroutine, shown in more detail in Table IV;

Figure 9 is a flowchart of an example of a DOCANCEL subroutine, shown in more detail in Table V.

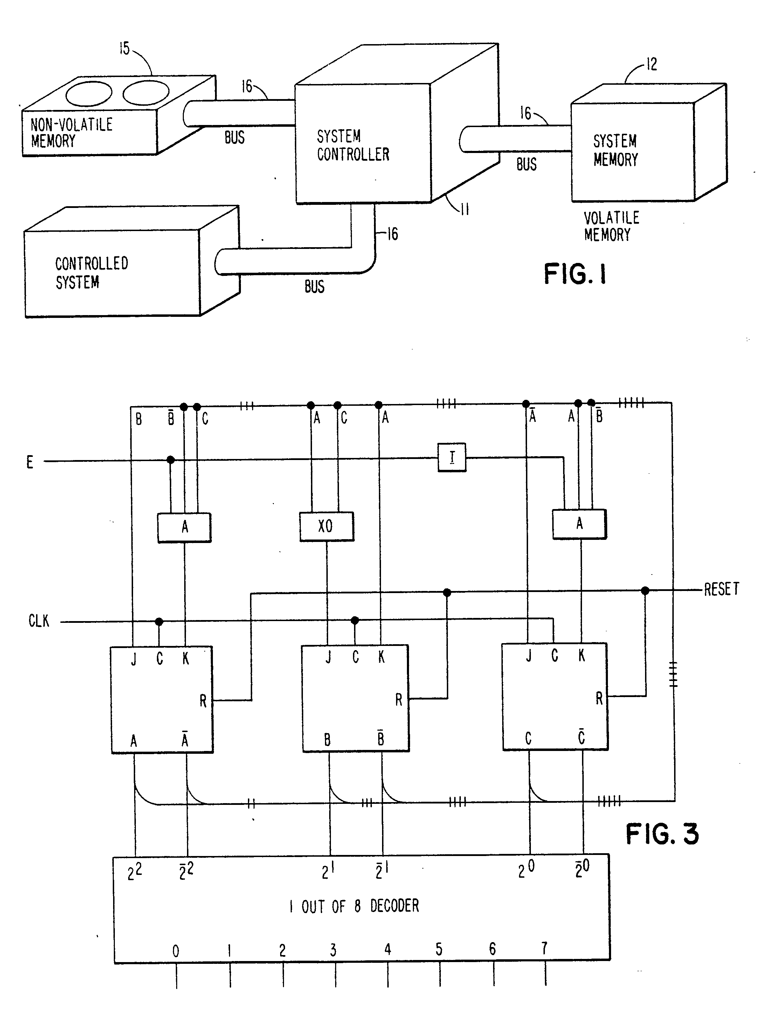

Figure 1 shows a data processing system having a system controller which is coupled by buses 16 to a system memory 12 and a controlled system 14 as well as to a nonvolatile memory 15 for storing programs and other information during power-off times. The nonvolatile memory 15 supplies bootstrap and other programs to the system controller 11 at power-up time to load the system memory 12 with programs, constants, and other data required for controlling the system 14. If the nonvolatile memory 15 is not properly functioning, an erroneous program or other data can cause the system controller to malfunction. Therefore, it is desirable to add a test unit between the nonvolatile memory and the system controller which will test the nonvolatile memory initially to ensure its proper operation.

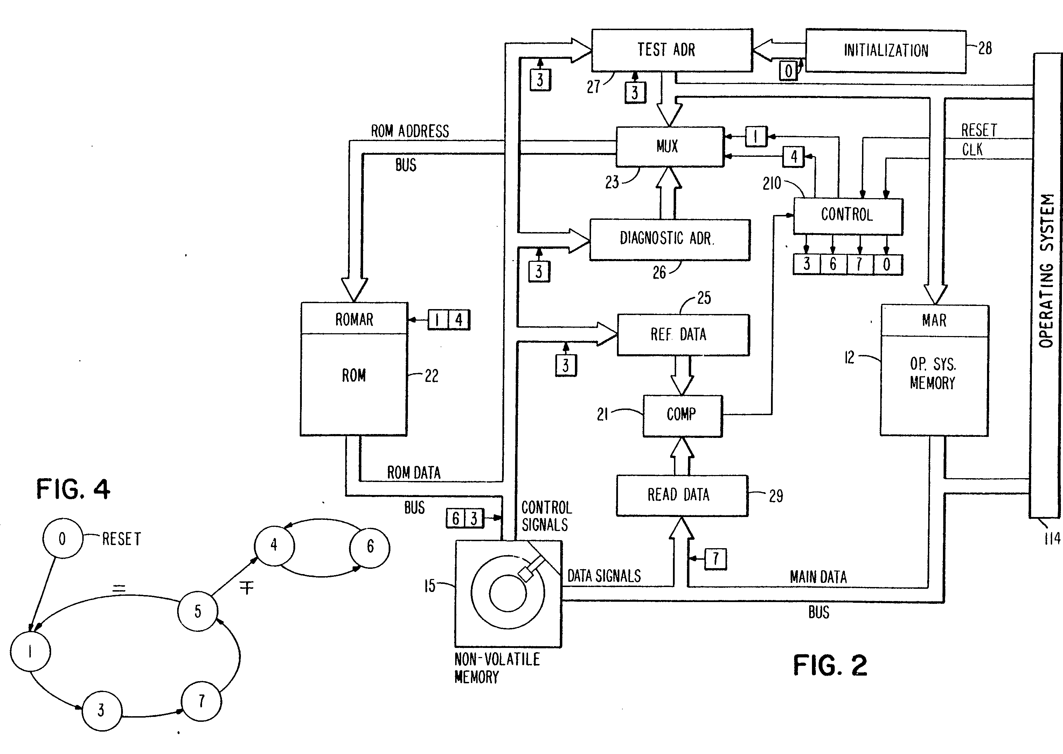

Such a testing system is shown in Figure 2. The operating system 114 comprises the system controller 11 and the controlled system 14. The system memory 12 is shown coupled to the operating system 114 by an address bus and a main data bus. The nonvolatile memory 15 is .coupled to the main data bus and to a data bus from a ROM 22. The ROM 22 has a ROM address bus coupled to a multiplexor 23. The data bus from the ROM supplies control signals to the nonvolatile memory 15 and data to a reference data register 25, a diagnostic address register 26, and test address register 27. The test address register 27 is initialized from a fixed value contained in an initialization register 28.

The data signals from the nonvolatile memory can be gated to the main memory 12 or to a read data register 29. The contents of the reference data register 25 and the read data register 29 are compared in comparator 21 which produces an output signal indicating that the contents of the registers 25 and 29 are equal.

The equality information is supplied to a controller 210 which also receives a reset signal and a clock signal from the operating system 114. The controller 210 produces output gating signals 0, 1, 3, 4, 6 and 7 and a further signal 5 which, in accordance with its condition, selects either 4 or 1 as the following signal.

Figure 3 is a logic diagram of a suitable control circuit for use in the system of Figure 2. Three JK clocked flip-flops are used in combination with a one-out-of-eight decoder and suitable feedback to produce output signals at the one-out-of-eight decoder in the sequence shown in Figure 4.

The state flow diagram of Figure 4 shows that the first output signal after a reset signal is state zero. At the next clock pulse, state one is entered from state zero and at successive clock pulses, the controller goes to states three, seven and five. At state five, the output signal from the comparator 21 (Figure 2) determines whether the next state is state one or state four. If the comparator indicates an equality, the state one is entered.

On the other hand, if the comparator indicates an inequality, the state four is entered. State four leads to state six which alternates with four.

The operation of the system of Figure 2 will now be described in detail. At power on time, a reset signal from the operating system 114 resets the controller 210 to the state zero. State zero gates the value from the initialization register 28 into the test address register 27. At the next clock pulse, the controller produces a state one signal which causes the multiplexor 23 to couple the test address to the ROM address bus and gate the value thereof into the ROM address register. At the next clock pulse, state three signals are supplied by the controller which gate the data from the ROM data bus into the various registers and into the control portion of the nonvolatile memory 15.

In the example being described, the nonvolatile memory is being tested by moving its read/write head to various tracks on a disc and confirming that the data is correct data, i.e., indicating that the head has homed on the right track. The read data is compared to known data to determine whether the head seeking operation is properly functioning. If not, a diagnostic routine is invoked which causes the head to select tracks in a given sequence for purposes of maintenance analysis by the maintenance personnel. Other tests might include read test, write test, and the like which can be designed by a person of ordinary skill in the art.

The control signals gated into the nonvolatile memory at state three cause the head to move to a particular track. The identifying data on that track is also stored in the ROM 22 and is gated at state three into the reference data register 25. A diagnostic program associated with a failure of the test being performed has its address stored in the diagnostic address register
26 at state three. The address of the next test is also gated
into the test address register 27 at state three.

The data signals from the nonvolatile memory are next gated
into the read data register 29 by state seven which follows state
three in response to a clock pulse from the operating system 114
after the nonvolatile memory 15 has positioned the head as directed.

If the data in the reference data register 25 and the contents
of the read data register 29 are equal, then the comparator 21
produces an equality output signal to the controller 210. At the
next state, five, the status of the equality is checked and, if
equal, produces state one which repeats the above-described sequence
until all tests have been completed.

If the comparator 21 produces an inequality signal, the
controller 210 supplies a state four signal which gates the address
of the diagnostic from the diagnostic address register 26 through
the multiplexor 23 to the ROM address register. The next state
six causes the output signals from the ROM data bus to be gated
into the control portion of the nonvolatile memory to perform the
diagnostic associated with the malfunction. The diagnostic is
repeated until a reset signal from the operating system 114 is
supplied to the controller. This reset signal can be invoked
manually by the maintenance personnel or automatically after a
predetermined number of diagnostic operations.

After the correct operation of the nonvolatile memory has
been verified, the operating system 114 supplies addresses through
the multiplexor 23 by driving the controller to the state one to a
location in the ROM 22 that causes the nonvolatile memory 15 to read that portion of the disc which contains the information to be transferred to the main memory 12. The operating system 114 also supplies the addresses to the main operating system memory 12 to store the data from the main data bus in the proper location.

A method and apparatus for testing a storage media and automatically invoking a diagnostic routine in response to malfunctions thereof have been described in conjunction with the Figure 2. These diagnostic routines may be performed under the control of a microprocessor in the system controller 11. An example of a suitable microprocessor is described in U.S. Patent Specification No. 4,086,658.

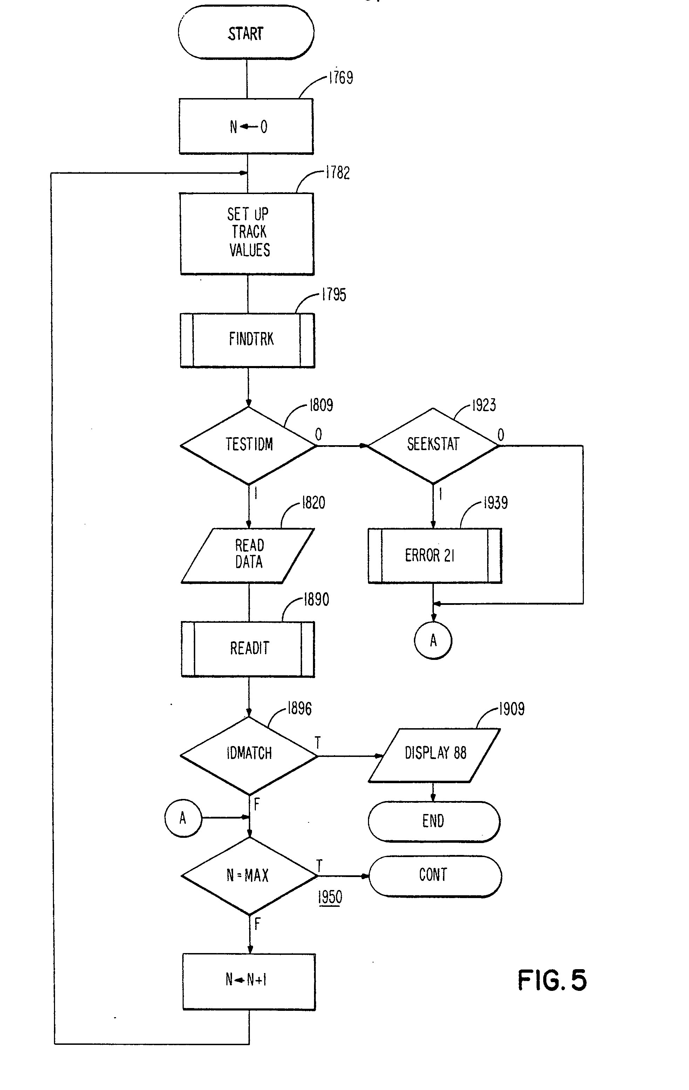

The flowchart of Figure 5 in conjunction with the program Table I describes the test program as performed in the system of Figure 2. The steps of the program in the flowchart of Figure 5 are labelled with reference numerals which correspond as closely as possible to the statement numbers of the assembly language program set forth in the Table. Since the assembly language is written in terms of mnemonics as set forth in U.S. Patent Specification No. 4,086,658, the details necessary to implement the program flowcharted in Figure 5 are amply supplied by the Tables. Appendix A summarizes the instruction repertoire and includes macro instruction mnemonics.

The first step of the test program is the setting of a counter N to zero at the step 1769. The next step 1782 sets the track values and calls a subroutine FINDTRK at the step 1795. This subroutine is not described in detail but is dependent on the particular disc drive used as the nonvolatile memory 15. This subroutine provides signals to the controller to position the head at a designated track. At the step 1809, a test table is accessed to determine whether the identification number written on the track has purposely been written erroneously. The Table may also be used to designate the next track to be sought.

In order to force a read error or track error, some tracks, not used for storing data, have a track purposely identified wrong.  As shown in Table I, a table is referenced with the track number which has a bit called the IDM bit, which when set indicates that the track ID can be expected to be wrong.  If the bit is set indicating a wrong ID number is to be expected, then at step 1820 the data is read from the disc and a subroutine READIT is called at the step 1890 to compare the data read with the expected data.  At the step 1896, if the ID's match, then an error is indicated and a display of 88, for example, is provided as shown at the step 1909 and the program is completed.  If the ID of the track does not match at the step 1896 as expected, the program continues by checking at the step 1950 to determine whether the final track has been tested.  If not, N is increased by one and the test is repeated.  If the last track has been tested, the program continues with the next test.

The incrementation of the N value in testing for N maximum is done in the program of Table I by means of a Repeat Until instruction.  In effect, however, the program operates as is shown in the flowchart of Figure 5.

At the step 1809, if an erroneous ID was not expected, then at step 1923 the status of the head is checked and, if in error, calls a subroutine ERROR 21 at the step 1939.  If there is no error, the program continues at the steps 1950 to determine whether the test has been completed.  As is described above, the test program tests every track and compares its identification number with a known value.  If this value is wrong and is expected to be wrong, no error exists.  Finding a matching identification number where one should not exist is treated as a separate error.  Finding a wrong ID where the correct ID should be is treated as a malfunction of the machine and a diagnostic to exercise the machine is invoked by the ERROR 21 subroutine as described below.

TABLE I:  SEEK TRACK TEST

```
STMT        SOURCE STATEMENT

31769                           1. N = 0;
31770 SEEKTEST LA    SEEKTABL
31772
31774
31775
31779           STR   N
31781                   .             1. REPEAT
31782                   .             2. . MOVE TRKSEEK (N) VALUES INTO
                                               BUFFER
31784 IGST0     LN    N
31787           STBL  TRKREQ
31790           OUT   IGCYL
31793           LRB   N
31795                                 2. . CALL (FINDTRCK);
31796           SRG   IRGB
31798
31802           BAL   BAL5,FINDTRCK
31804           SRG   IRGA
31806
31809                                 2. . IF TESTIDM SET
31811           LN   ·N
31814           TP    TESTIDM
31817           BE    IGST2
31819                           2. . THEN
31820                           3. . . READ DATA (WRONG N-REG VALUE);
31822           LBL   ERRFLAGS
31825           TR    RDERRFB
31828           STBL  ERRFLAGS
31830           SRG   IRGB
31832
31835           LA    NRDBUF
31837
31839
31840
31844           STR   READBUFF
31846           LA    CHECKNID
31848
31850
31851
31855           STR   CHECK
31858           LI    X'80'
31861           STBL  LEN
```

```
STM        SOURCE STATEMENT

31864           LI   X'01'
31867           OUT  IGN
31870           LI   X'41'
31873           OI   X'10'     ABORTEST FLAG
31876           STBL CHKFLAGS
31879           LI   X'01'
31882           STBL SEC
31885           LBL  TRKREQ
31888           STBL TRACK
31890                          3. . . CALL (READIT) (READIT2);
31892           BAL  BAL4,READIT2
31894           SRG  IRGA
31896
31899                          3. . . IF IDMATCH TRUE
31901           LBL  STATERR
31904           TP   IDMATCH
31907           BNE  IGST1
31909                          3. . . THEN
31910                          4. . . . PROCESS (PLNAR88) IDM ALWAYS
31911                                       MATCHED;
31912           SRG  GPSPVCE1
31914
31918           BU   PLNAR88,BU88
31921                          3. . . ENDIF;
31922                          2. . ELSE
31923                          3. . . IF SEEKSTAT FALSE
31925 IGST2     LBL  SEEKSTAT
31928           TP   0
31931           BNE  IGST1
31933                          3. . . THEN
31934           SRG  IRGB
31936
31939                          4. . . . CALL (ERROR) 21;
31941           BAL  BAL6,IGERR021
31943           SRG  IRGA
31945
31948                          3. . . ENDIF;
31949                          2. . ENDIF;
31950                          1. UNTIL N = MAXSEEKT
31952 IGST1     LRB  N
31954           LA   MAXSEEKT
31956
31958
31959
31963           SR   N
31966           BNE  IGST0
31968                          1. ENDREPEAT;

31969                          1. RETURN;
31971           RTN  RET1
```

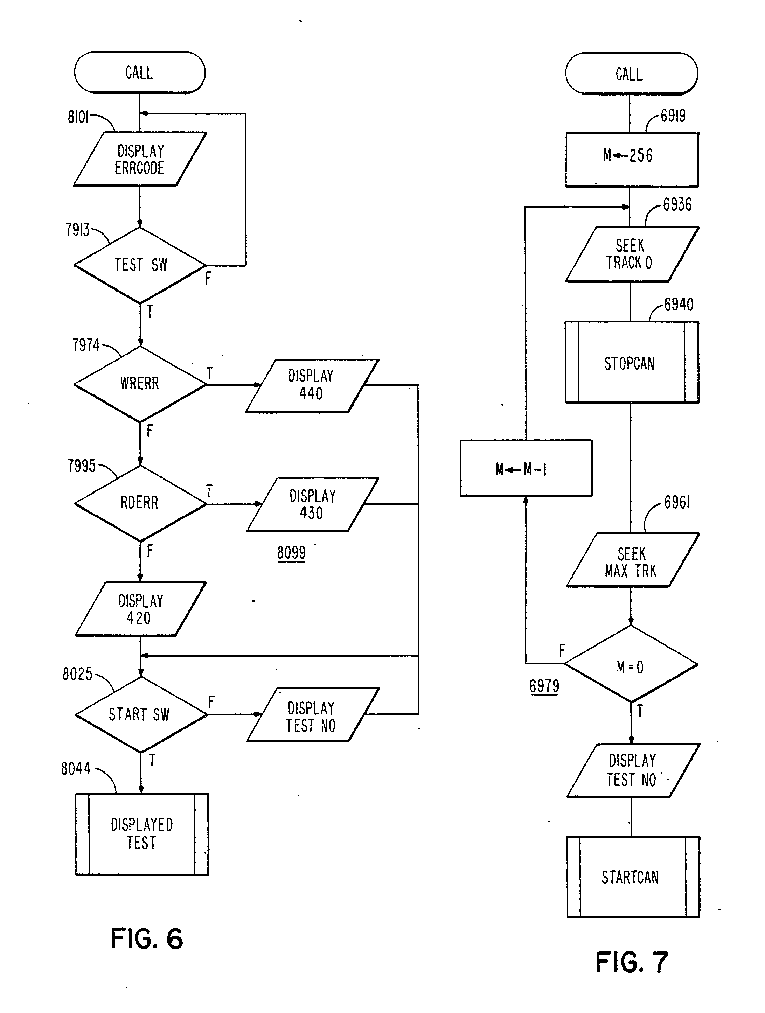

The flowchart of Figure 6 describes the essential steps performed in selecting the correct diagnostic test corresponding to the malfunction detected in the previously-described test. The subroutine is called and displays the error code which can be an arbitrary number. At the step 8101 a test switch is sensed at the step 7913 to determine whether the program should be continued. Such a switch is desirable to cause the program to continue at the time desired for diagnosing the problem. For example, when used in a copier, the error code displayed would indicate that maintenance personnel should be informed and continuation of the test would require waiting until such maintenance personnel were available.

When the test switch is pressed, a test is made at the step 7974 to determine whether a write error occurred. If so, the test 440 is selected and the number 440 is displayed. If a write error did not occur, then the machine is checked to determine whether a read error occurred by the step 7995 and, if so, the test number 430 is selected and displayed. If a read error did not occur, then it is assumed that the head was positioned at the incorrect track and a test number 420 is selected and the number 420 displayed. The display step in Table II is shown beginning at statement 8099. At the step 8025, the start switch is sensed to determine whether the diagnostic test should commence. If not, the test number is continually displayed until the start button is pressed, at which time the displayed test is performed as shown by the subroutine call 8044.

- 13 -

TABLE II:   ERROR 21

STMT      SOURCE STATEMENT

```
7913                              1. IF CE BUTTON PUSHED
7915           TRA
7917           TP    STRTFLGB
7920           BNE   ACTIVEON
7922                              1. THEN
7923
7924
7925
7926
7927
7928
7929
7932                              2. . SET DIAGNOSTIC ADDRESSES;
7933           LA    ORGIGR01
7935
7937
7938
7942           STR   S420ADR
7944           LA    ORGIGR02
7946
7948
7949
7953           STR   S430ADR
7955           LA    ORGIGR03
7957
7959
7960
7964           STR   S440ADR
7966                              2. . SET UNITS DISPLAY = 0;
7968           LI    X'3F'
7971           STBL  UNITSB
7973
7974                              2. . IF 43FD 44X ERROR CODE
7976           LR    SDISPREG
7979           TP    6
7982           JE    CK43X
7984                              2. . THEN
7985                              3. . . SET UP TO INVOKE DIAGNOSTIC
                                         ROUTINE 440;
7988           LR    S440ADR
7991           J     INVOKE
7994                              2. . ELSE
7995                              3. . . IF 43FD 43X ERROR CODE
7997 CK43X     TP    4
8000           JE    STRT420
8002                              3. . . THEN
8003                              4. . . . SET UP TO INVOKE DIAGNOSTIC
8004                                         ROUTINE 430;
```

```
STMT      SOURCE STATEMENT

8006           LR    S430ADR
8009           J     INVOKE
8012                            3. . . ELSE
8013                            4. . . . SET UP TO INVOKE DIAGNOSTIC
8014                                      ROUTINE 420;
8017 STRT420  DC    *
8019           LR    S420ADR
8021                            3. . . ENDIF;
8022                            2. . ENDIF;
8023                            2. . SET RETURN ADDRESSES;
8025 INVOKE   STR   GOTOREG
8027           LA    WAITSTRT
8029
8031
8032
8036           STR   CALLBAL
8038                            2. . PROCESS (WAITSTRT) WAIT FOR START
8039                                     BUTTON;
8040                            2. . NOTE NO RETURN WILL BE MADE TO
8041                                     THIS POINT.  SEE WAITSTRT
8042                                     ROUTINE FOR NEXT ACTION;
8044           B     WAITSTRT
8047                            1. ENDIF;
8050 ACTIVEON DC    *
8051                            1. ALLOW TIME FOR START BUTTON
                                     DEBOUNCE;
8054 SPVBDLY4 DC    *
8056           CLA
8058           STR   BOUNCERG
8061           LI    X'FF'
8064           STR   BUTNCTR
8068 SPVBDLY5 DC    *
8070           IN    BUTNBYTE
8073           TP    STARTBIT
8076           JE    SPVBDLY6
8079           LRB   BOUNCERG
8083 SPVBDLY6 DC    *
8085           LRD   BUTNCTR
8088           JNE   SPVBDLY5
8091           LR    BOUNCERG
8094           CI    X'00'
8097           JNE   SPVBDLY4
8099                            1. TURN ON TEST ACTIVE INDICATOR;
8101           LI    X'F0'
8104           OUT   X'10'
8107           LI    TSTACTVL
8110          OUT   TSTACTVB
8112                            1. RETURN TO CALLING ROUTINE;
8114           RTN   COMBAL
```

- 15 -

The program flowchart of Figure 7 shows a diagnostic routine for moving the head between the high and low tracks continuously to provide maintenance personnel the opportunity to inspect waveforms, voltages at various points, and so on to diagnose the problem.  The details of the program are shown in Table III.

At step 6919 it is assumed that the head seek routine will be performed 256 times so a test value M is set to that number.  At the step 6936, a signal is sent to the nonvolatile memory disc apparatus 15 to place the head on track zero.  At the step 6940, the STOPCAN subroutine is performed which will be described below in more detail. After return from the subroutine STOPCAN, a command is sent to cause the head to seek the maximum track at the step 6961.  By means of a repeat instruction at statement 6979, the value of M is tested for zero.  If not zero, M is decremented by one and the program beginning at the step 6936 is repeated until the value of M is zero at which time the test number is again displayed, the machine is stopped and the subroutine STARTCAN is invoked.

- 16 -

TABLE III: DIAGNOSTIC

```
STMT       SOURCE STATEMENT

SEEKALIN SRG    IRGA

                              1. CALL (SETUPIG);
         BAL    BAL1,SETUPIG
         SRG    IRGB

         LI     X'00'
         STBL   ROT
                              1. SET LENGTH REGISTER;
         LI     X'4C'
         OUT    IGLEN
                              1. REPEAT
                              2. . NOTE UNTIL LOOP COUNT = 256 OR
                                      MANUALLY STOPPED;
                              2. . SET CYLINDER = 00;
IGSKAL1  LI     X'00'
         OUT    IGCYL
                              2. . CALL (SEEKLOER);
         BAL    BAL7,SEEKLOER
                              2. . CALL (ORGSCAN) TEST STOP/CANCEL;
         SRG    GPSPVCE1

         BAL    COMBAL,ORGSCAN
         SRG    IRGB

                              2. . SET CYLINDER = 76;
         LI     X'4C'
         OUT    IGCYL
                              2. . CALL (SEEKHIER);
         BAL    BAL7,SEEKHIER
                              2. . CALL (ORGSCAN) TEST STOP/CANCEL;
         SRG    GPSPVCE1

         BAL    COMBAL,ORGSCAN
         SRG    IRGB

                              1. UNTIL LOOP COUNT = 256 OR MANUALLY
                                      STOPPED
         LBL    ROT
         AI
         STBL   ROT
         CI     X'00'
         BNE    IGSKAL1
                              1. ENDREPEAT;
         SRG    GPSPVCE1

                              1. RETURN;
         RTN    CALLBAL
```

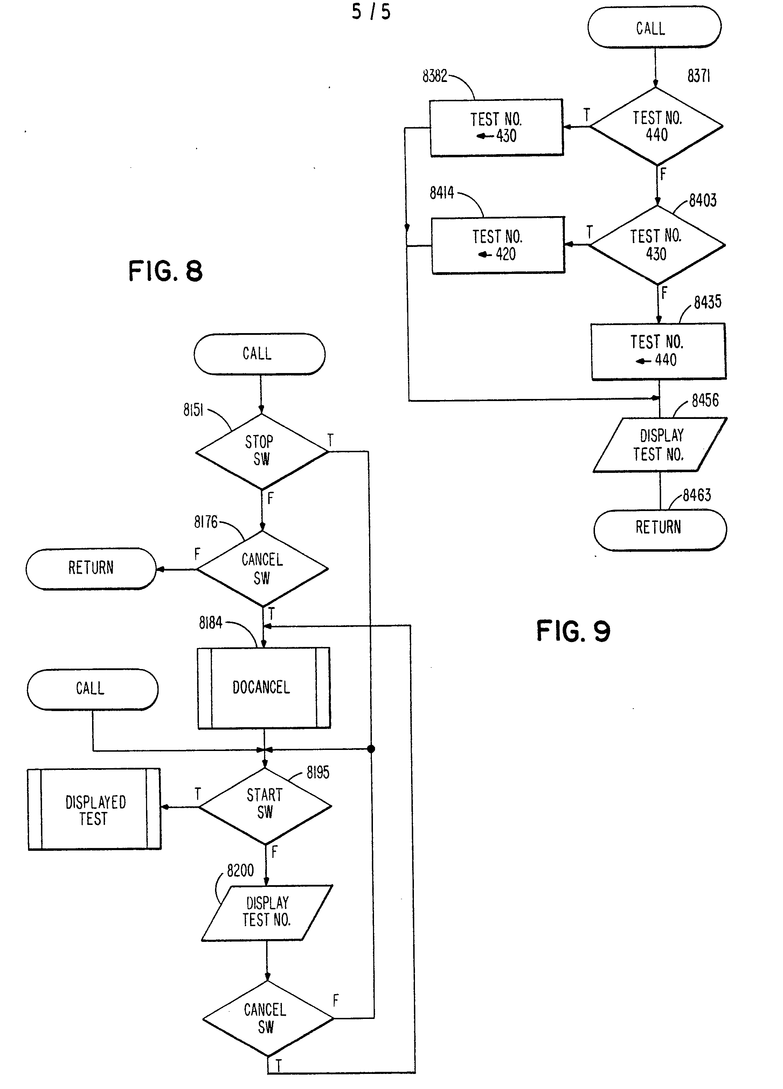

The flowchart of Figure 8 shows the STOPCAN and STARTCAN
subroutines. The call into step 8155 is performed when the STOPCAN
subroutine is called. The stop switch is sensed by step 8155, and if
found set, branches to the STARTCAN portion of the subroutine at the
step 8195. If the stop switch at the step 8155 is not activated, the
cancel switch is sensed at step 8176. If the cancel switch has not been
activated, the subroutine returns to the calling routine.

If the cancel switch is activated at the step 8176, the subroutine
DOCANCEL is called by the step 8184. This will be described in more
detail below. At the completion of the DOCANCEL subroutine at the step
8184, the STARTCAN subroutine is entered beginning at the step 8195
which is the call entry point for the STARTCAN routine.

The STARTCAN subroutine first senses the start switch to determine
whether it has been pressed. If so, the displayed test is repeated. If
not, the test number is displayed as shown at the step 8200 and the
cancel switch is again sensed. If the cancel switch has not been
pressed, the STARTCAN subroutine is repeated. If the cancel switch has
been pressed, the DOCANCEL subroutine is called as previously described.
The essential details of the STOPCAN and STARTCAN subroutines are shown
in Table IV.

0031498

TABLE IV:  STOP/STARTCAN


STMT        SOURCE STATEMENT

```
8140 STOPCAN     DC    *
8141                               1. TURN OFF TEST ACTIVE INDICATOR;
8143               LI    X'F0'
8146               OUT   X'10'
8149               CLA
8151               OUT   TSTACTVB
8153                               1. IF STOP BUTTON PUSHED
8155               LI    X'E0'
8158               OUT   X'10'
8161               IN    BUTNBYTE
8164               TP    STOPBIT
8166                               1. THEN
8167                               2. . PROCESS (WAITSTRT) WAIT FOR START
8168                                         BUTTON;
8169                               2. . NOTE NO RETURN WILL BE MADE TO
8170                                         THIS POINT, SEE WAITSTRT
8171                                         ROUTINE FOR NEXT ACTION;
8173               JNE   WAITSTRT
8175                               1. ELSE
8176                               2. . IF CANCEL BUTTON PUSHED
8178               TP    CANBIT
8181               JE    RETRN
8183                               2. . THEN
8184                               3. . . CALL (DOCANCEL) CANCEL TEST
8185                                         AND SET UP FOR NEXT TEST;
8187               BAL   BAL2REG,DOCANCEL
8189                               3. . . PROCESS (WAITSTRT) WAIT FOR
8190                                         START BUTTON;
8191                               3. . . NOTE NO RETURN WILL BE MADE TO
8192                                         THIS POINT, SEE WAITSTRT
8193                                         SECTION FOR NEXT ACTION;
8195               J     WAITSTRT
8198                               2. . ENDIF;
8199                               1. ENDIF;
8200                               1. TURN ON TEST ACTIVE INDICATOR;
8203 RETRN         DC    *
8205               LI    X'F0'
8208               OUT   X'10'
8211               LI    XTLACTVL
8214               OUT   TSTACTVB
8216                               1. RETURN TO CALLING ROUTINE;
8218               RTN   COMBAL
```

The DOCANCEL subroutine is flowcharted in Figure 9. The purpose of this subroutine is to permit the operator or maintenance personnel to cancel the test being performed and select additonal tests in sequence. In operation, the maintenance personnel pushes the button to select the next test in sequence, the number of which is displayed. If that is not the desired test, the button is pressed again and the next test in sequence is selected and displayed. When the desired test has been selected and displayed, then the maintenance personnel presses the start button to execute the desired test being displayed.

The DOCANCEL subroutine is entered at the step 8371 which senses for test number 440. If test number 440 was being performed, the test number is changed at the step 8382 to test number 430. If test 440 was not being performed, then at the step 8403, test number 430 is checked and if being performed, the test number is changed to test 420. If the test 430 was not being performed, then at the step 8435, the test number 440 is selected. The test number selected is then displayed by the step 8456 and the subroutine returns to the calling program at step 8463. The details of the subroutine are shown in Table V.

TABLE V:  DOCANCEL


STMT     SOURCE STATEMENT

```
8322 DOCANCEL DC    *
8323                      1. ALLOW TIME FOR BUTTON DEBOUNCE;
8326 SPVBDLY1 DC    *
8328          CLA
8330          STR   BOUNCERG
8333          LI    X'FF'
8336          STR   BUTNCTR
8340 SPVBDLY2 DC    *
8342          IN    BUTNBYTE
8345          TP    CANBIT
8348          JE    SPVBDLY3
8351          LRB   BOUNCERG
8355 SPVBDLY3 DC    *
8357          LRD   BUTNCTR
8360          JNE   SPVBDLY2
8363          LR    BOUNCERG
8366          CI    X'00'
8369          JNE   SPVBDLY1
8371                      1. IF CURRENT TEST = 440
8373          LR    SDISPREG
8376          TP    6
8379          JE    CK430
8381                      1. THEN
8382                      2. . SET UP TO RUN 430;
8384          SI    X'10'
8387          STR   SDISPREG
8390          LR    S430ADR
8393          STR   GOTOREG
8396          LI    X'4F'
8399          B     ALDISP
8402                      1. ELSE
8403                      2. . IF CURRENT TEST = 430
8406 CK430    DC    *
8408          TP    4
8411          JE    SET440
8413                      2. . THEN
8414                      3. . . SET UP TO RUN 420;
8416          SI    X'10'
8419          STR   SDISPREG
8422          LR    S420ADR
8425          STR   GOTOREG
8428          LI    X'5B'
8431          J     ALDISP
```

```
STMT      SOURCE STATEMENT

8434                           2. . ELSE
8435                           3. . . SET UP TO RUN 440;
8438 SET440   DC   *
8440          AI   X'20'
8443          STR  SDISPREG
8446          LR   S440ADR
8449          STR  GOTOREG
8452          LI   X'66'
8454                           2. . ENDIF;
8455                           1. ENDIF;
8456                           1. CHANGE LED DISPLAY;
8459 ALDISP   DC   *
8461          STBL TENSB
8463                           1. RETURN TO CALLING ROUTINE;
8465          RTN  BAL2REG
```

APPENDIX A

| INSTRUCTION MNEMONIC | HEX VALUE | NAME | DESCRIPTION |
|---|---|---|---|
| AB | A4 | Add Byte | Adds addressed operand to ACC |
| AI | AC | Add Immed. | Adds address field to ACC |
| AR | DN | Add Reg. | Adds N-th register to ACC |
| A1 | 2E | Add One | Adds 1 to ACC |
| B | 24,28,2C | Branch | Branch to LSB (+256,-256,+0) |
| BAL | 30-33 | Branch And Link | Used to call subroutines |
| BE | 35,39,3D | Branch Equal | Branches if EQ set |
| BH | 36,3A,3E | Branch High | Branch if EQ and LO are reset |
| BNE | 34,38,3C | Branch Not Equal | Branch if EQ reset |
| BNL | 37,3B,3F | Branch Not Low | Branch if LO reset |
| CB | A0 | Compare Byte | Addressed byte compared to ACC |
| CI | A8 | Compare Immed. | Address field compared to ACC |
| CLA | 25 | Clear Acc. | ACC reset to all zeroes |
| GI | A9 | Group Immed. | Selects one of 16 register groups |
| IC | 2D | Input Carry | Generate carry into ALU |
| IN | 26 | Input | Read into ACC from addressed device |
| J | ON,1N | Jump | Jump forward or back using N-th register |
| JE | 4N,5N | Jump Equal | Jump if EQ set |
| JNE | 6N,7N | Jump Not Equal | Jump if EQ reset |
| LB | A6 | Load Byte | Load addressed byte into ACC |
| LDR | FN | Load/Decr.Reg. | Load reg. N and decrement (N=0-3,8-B) |
| LI | AE | Load Immed. | Load address field into ACC |
| LN | 98-9F | Load Indirect | Load byte addressed by reg. N into ACC |
| LR | EN | Load Register | Load register N into ACC |
| LRB | FN | Load Reg./ Bump | Load reg. N and increment (N=4-7,C-F) |
| NB | A3 | And Byte | AND addressed byte into ACC |
| NI | AB | And Immed. | AND address field into ACC |
| OB | A7 | Or Byte | OR addressed byte into ACC |
| OI | AF | Or Immed. | OR address field into ACC |
| OUT | 27 | Output | Write ACC to addressed device |
| RTN | 20-23 | Return | Used to return to calling program (See BAL.) |
| SB | A2 | Subtract Byte | Subtract addressed byte from ACC |
| SHL | 2B | Shift Left | Shift ACC one bit left |
| SHR | 2F | Shift Right | Shift ACC one bit right |

| INSTRUCTION MNEMONIC | HEX VALUE | NAME | DESCRIPTION |
|---|---|---|---|
| SI | AA | Subtract Immed. | Subtract address field from ACC |
| SR | CN | Subtract Reg. | Subtract reg. N from ACC |
| STB | A1 | Store Byte | Store ACC at address |
| STN | B8-BF | Store Indirect | Load ACC at address in reg. |
| STR | 8N | Store Reg. | Store reg. N at address |
| S1 | 2A | Subtract One | Subtract 1 from ACC |
| TP | 9N | Test/Preserve | Test N-th bit in ACC (N=0-7) |
| TR | BN | Test/Reset | Test and reset N-th bit in ACC |
| TRA | 29 | Transpose | Interchange high and low ACC bytes |
| XB | A5 | XOR Byte | Exclusive OR addressed byte into ACC |
| XI | AD | XOR Immed. | Exclusive OR address field into ACC |

Notes: ACC (Accumulator) is 16-bit output register from arithmetic-logic unit

- all single byte operations are into low byte
- all byte and immediate operations are single byte operations
- register operations are 16-bit (two-byte)

EQ (equal) is a flag which is set:

if ACC=0 after register AND or XOR operations;
if ACC (low byte)=0 after single byte operation;
if a tested bit is 0;
if bits set by OR were all 0's;
if input carry = 0;
if compare operands are equal;
if bit shifted out of ACC = 0;
if 8th bit of data during IN or OUT = 0.

LO (low) is a flag which is set: (always reset by IN, OUT, IC)

if ACC bit 16=1 after register operation;
if ACC bit 8=1 after single byte operations;
if logic operation produces all ones;
if all bits other than tested bit = 0;
if ACC=0 after shift operation;
if compare operand is greater than ACC low byte.

| MACRO MNEMONIC | NAME | DESCRIPTION |
|---|---|---|
| BC | Branch on Carry | Branches if carry is set |
| BL | Branch on Low | Branches if LO is set |
| BNC | Branch Not Carry | Branches if carry is reset |
| BNZ | Branch Not Zero | Branches if previous result was not zero |
| BR | Branch via Register | Same as RTN instruction |
| BU | Branch Unconditionally | Same as BAL instruction |
| CIL | Compare Immed. Low | Uses low byte of indicated constant in CI address field |
| DC | Define Constant | Reserves space for constant |
| JC | Jump on Carry | See BC |
| JL | Jump on Low | See BL |
| JNC | Jump on No Carry | See BNC |
| LA | Load Address | Generates sequence LIH, TRA, LIL |
| LRD | Load Reg. and Decrement | Same as LDR instruction |
| LIH | Load Immed. High | Uses high byte of constant in LI address field |
| LIL | Load Immed. Low | Uses low byte of constant in LI address field |
| NOP | No Operation | Dummy instruction - skipped |
| RAL | Rotate and Add Left | Generates sequence SHL, IC, Al |
| SHLM | Shift Left Multiple | Shifts specified number of times to left |
| SHRM | Shift Right Multiple | Shifts specified number of times to right |
| SRG | Set Register Group | Same as GI |
| TPB | Test & Preserve Bit | Generates sequence LB, TP |
| TRB | Test & Reset Bit | Generates sequence LB, TR, STB |
| TRMB | Test & Reset Multiple Bits | Same as TRB but specifies multiple bits |
| TS | Test and Set | Same as OI instruction |
| TSB | Test & Set Byte | Same as TS but byte is specified in addition to bit |
| TSMB | Test & Set Multiple Bytes | Same as TS but specifies multiple Bits |

NOTES: (Label) DC * causes the present location (*) to be associated with the label.

L and H, in general, are suffixes indicating low or high byte when 16 bit operands are addressed.

- 25 -

CLAIMS

1.    A digital data processing system comprising a non-volatile data store (15) which is coupled through a system controller (11) to a volatile data store (12) and a data processor (14), the system being operable to save data during power-off periods by storing data from the volatile store in the non-volatile store and to transfer data from the non-volatile store to the volatile store during a power-on sequence following a power-off period characterised by verifying means for verifying data from the non-volatile store prior to transfer to the volatile store during a power-on sequence, said verifying means comprising a read-only store (22), first means (27) for providing a sequence of test addresses to the read-only store to derive therefrom, for each test address, a non-volatile store reference address, reference data related to test data at the reference address, and an address of a diagnostic routine in the read-only store related to a portion of the non-volatile store including the reference address, second means (25) for holding said reference data, third means (26) for holding said diagnostic address, fourth means (29) for holding data read from the reference address, and comparing means (21) for comparing the contents of said second and fourth means to provide, in accordance with the relationship of data therein, an output to control means (210) to cause the control means either to direct the next test address in the sequence, or said diagnostic address, to the read-only store.

2.    A digital data processing system as claimed in claim 1 further characterised in that said control means is effective to control data transfer from the non-volatile store to the volatile store subsequent to the application of all of the test addresses in the sequence to the read-only store.

3.    A digital data processing system as claimed in claim 1 or claim 2 further characterised in that said non-volatile store is a disc file and each of said reference addresses relates to an associated track of the disc file.

0031498

1/5

FIG. I

FIG. 3

FIG. 4

FIG. 2

2/5

0031498

0031498

```
                    START

                              ─1769
                   N ← 0

                              ─1782
                  SET UP
                  TRACK
                  VALUES

                              ─1795
                  FINDTRK

        1809                        1923
      TESTIDM ──0── SEEKSTAT ──0──
        │1                      │1
                                        1939
        1820
      READ                    ERROR 21
      DATA

        1890
      READIT                      A

        1896
      IDMATCH ──T── DISPLAY 88      1909

   A ──F                      END

      N = MAX ──T── CONT
       1950
        │F

      N ← N+1
```

**FIG.5**

**FIG. 6**

```
        ( CALL )
           │
8101 ──  ┌─────────┐
         │ DISPLAY │ ◄────┐
         │ ERRCODE │      │
         └─────────┘      │
           │              │
7913 ──   ◇ TEST SW ──F───┘
           │
           T
           │
7974 ──   ◇ WRERR ──T──► ┌─────────┐
           │             │ DISPLAY │
           F             │  440    │
           │             └─────────┘
7995 ──   ◇ RDERR ──T──► ┌─────────┐
           │             │ DISPLAY │
           F             │  430    │
           │             └─────────┘
         ┌─────────┐        8099
         │ DISPLAY │
         │  420    │
         └─────────┘
           │
8025 ──   ◇ START SW ──F──► ┌───────────┐
           │                │ DISPLAY   │
           T                │ TEST NO   │
           │                └───────────┘
8044 ──  ┌───────────┐
         │ DISPLAYED │
         │   TEST    │
         └───────────┘
```

**FIG. 7**

```
        ( CALL )
           │
6919 ──  ┌─────────┐
         │ M ← 256 │
         └─────────┘
           │
6936 ──  ┌───────────┐ ◄────┐
         │ SEEK      │      │
         │ TRACK 0   │      │
         └───────────┘      │
           │                │
6940 ──  ┌───────────┐   ┌─────────┐
         │ STOPCAN   │   │ M ← M-1 │
         └───────────┘   └─────────┘
           │                │
6961 ──  ┌───────────┐      │
         │ SEEK      │      │
         │ MAX TRK   │      │
         └───────────┘      │
           │                │
          ◇ M = 0 ──F───────┘
           │  6979
           T
           │
         ┌───────────┐
         │ DISPLAY   │
         │ TEST NO   │
         └───────────┘
           │
         ┌───────────┐
         │ STARTCAN  │
         └───────────┘
```

0031498

## FIG. 9

```
                    ┌──────────┐
                    │   CALL   │
                    └────┬─────┘
                         │ 8371
              ┌──────────┴──────────┐
   8382       │      TEST NO.       │
┌──────────┐ T│        440          │
│ TEST NO. │◄─┤                     │
│  ◄─430   │  └──────────┬──────────┘
└────┬─────┘             │F
     │          8414     │ 8403
     │       ┌──────────┐│
     │     T │ TEST NO. ││  TEST NO.
     │   ◄───┤  ◄─420   ││    430
     │       └──────────┘│
     │                   │F
     │                   │ 8435
     │         ┌─────────┴────────┐
     │         │    TEST NO.      │
     │         │    ◄─440         │
     │         └─────────┬────────┘
     │                   │ 8456
     └───────────┐  ┌────┴─────┐
                 │  │ DISPLAY  │
                 └─►│ TEST NO. │
                    └────┬─────┘
                         │ 8463
                    ┌────┴─────┐
                    │  RETURN  │
                    └──────────┘
```

## FIG. 8